# EUROPEAN PATENT APPLICATION

(11) **EP 1 947 919 A2**
(43) Date of publication of application: **23.07.2008**
(21) Application number: 07106419.0
(22) Date of filing: 18.04.2007
(51) Int. Cl.: H05K 5/02

(54) **Holder for a plurality of memory devices**

(30) Priority: 26.03.2007 US 691118; 18.01.2007 US 885424 P
(71) Applicant: Fiorentino, Carl, Ohio Fletcher, OH 45326 (US)
(72) Inventor: Fiorentino, Carl, Ohio Fletcher, OH 45326 (US)
(74) Representative: Free, Rachel Alder

(57) **Abstract**

One embodiment of the present invention relates to a holder for a plurality of memory devices. In one example, the memory devices may be flash drives (e.g., USB flash drives). In another example, the holder may be in the form of a card (e.g., generally in the form of a credit card).

## Description

### RELATED APPLICATIONS

This application claims the benefit of United States Provisional Application Ser. No. 60/885,424, filed January 18, 2007. This application also claims the benefit of United States Design Application Ser. No. 29/276,923, filed February 9, 2007. This application also claims the benefit of United States Design Application Ser. No. 29/275,044, filed December 11, 2006. Each of the aforementioned applications is incorporated herein by reference in its entirety.

### FIELD OF THE INVENTION

One embodiment of the present invention relates to a holder for a plurality of memory devices.

In one example, the memory devices may be flash drives (e.g., USB flash drives).

In another example, the holder may be in the form of a card (e.g., generally in the form of a credit card).

### BRIEF DESCRIPTION OF THE DRAWINGS

Fig. 1 shows a perspective view (generally showing a top side) of a holder for a plurality of memory devices according to one embodiment of the present invention (in the example of this Fig. 1, six USB flash drives as the memory devices to be held are shown);
Fig. 2 shows a perspective view (generally showing a bottom side) of the holder of Fig. 1 (again, in the example of this Fig. 2, six USB flash drives as the memory devices to be held are shown);
Fig. 3 shows a perspective view (generally showing a top side) of the holder of Fig. 1 (again, in the example of this Fig. 3, six USB flash drives as the memory devices to be held are shown);
Fig. 4 shows detail of one side of one of the USB flash drives of Figs. 1-3;
Fig. 5 shows a plan view (generally showing a top side) of the holder of Fig. 1 (again, in the example of this Fig. 5, six USB flash drives as the memory devices to be held are shown);
Fig. 6 shows a perspective view (generally showing a bottom side) of the holder of Fig. 1 (in the example of this Fig. 6, the six USB flash drives are shown held by the holder- as opposed to the preceding Figs, in which the six USB flash drives are adjacent the holder);
Fig. 7A shows a plan view (generally showing a top side) of the holder of Fig. 1 (in the example of this Fig. 7A, the six USB flash drives are shown held by the holder - as in Fig. 6);
Fig. 7B shows a side view of the holder of Fig. 1 (in the example of this Fig. 7B, the USB flash drives are shown held by the holder - as in Fig. 6);
Fig. 8 shows a perspective view (generally showing a top side) of the holder of Fig. 1 (in the example of this Fig. 8, the six USB flash drives are shown held by the holder - as in Fig. 6);
Fig. 9 shows another perspective view (generally showing a top side) of the holder of Fig. 1 (in the example of this Fig. 9, four USB flash drives are shown held by the holder, with two recesses being empty);
Fig. 10 shows a perspective view (generally showing a top side) of the holder of Fig. 1 (in the example of this Fig. 10, five USB flash drives are shown held by the holder in a stored position (with the electrical contacts facing in, towards the holder) and one USB flash drive is shown held in a deployed position (with the electrical contacts facing out, for use - such as for being plugged into a computer USB port));
Fig. 11 shows a perspective view (generally showing a bottom side) of the holder of Fig. 1 (in the example of this Fig. 11, five USB flash drives are held by the holder in a stored position (with the electrical contacts facing in, towards the holder) and one USB flash drive is shown held in a deployed position (with the electrical contacts facing out, for use - such as for being plugged into a computer USB port));
Fig. 12 shows a plan view (generally showing a top side) of a holder according to another embodiment of the present invention (in the example of this Fig. 12, the six USB flash drives are shown held by the holder - in addition, various indicia used for identifying the USB flash drives are shown);
Fig. 13 shows a perspective view (generally showing a top side) of the holder of Fig. 12 (in the example of this Fig. 13, the six USB flash drives are shown partially held by the holder);
Fig. 14 shows a more detailed view of a portion of the holder of Fig. 13;
Fig. 15 shows a more detailed view of a portion of the holder of Fig. 12 (with one of the USB flash drives removed from the holder);
Fig. 16 shows a plan view (generally showing a bottom side) of the holder of Fig. 12 (various indicia used for identifying the USB flash drives are shown on the bottom side of the holder in this embodiment);
Fig. 17 shows a perspective view (generally showing a top side) of a holder according to another embodiment of the present invention (in the example of this Fig. 17, the one USB flash drive is shown held by the holder);
Fig. 18 shows a plan view (generally showing a top side) of the holder of Fig. 17; and
Fig. 19 shows a perspective view (generally showing a top side) of the holder of Fig. 17 (showing the flash drive adjacent the holder).

Among those benefits and improvements that have been disclosed, other objects and advantages of this invention will become apparent from the following description taken in conjunction with the accompanying figures. The figures constitute a part of this specification and include illustrative embodiments of the present invention and illustrate various objects and features thereof.

### DETAILED DESCRIPTION OF THE INVENTION

Detailed embodiments of the present invention are disclosed herein; however, it is to be understood that the disclosed embodiments are merely illustrative of the invention that may be embodied in various forms. In addition, each of the examples given in connection with the various embodiments of the invention are intended to be illustrative, and not restrictive. Further, the figures are not necessarily to scale, some features may be exaggerated to show details of particular components. Therefore, specific structural and functional details disclosed herein are not to be interpreted as limiting, but merely as a representative basis for teaching one skilled in the art to variously employ the present invention.

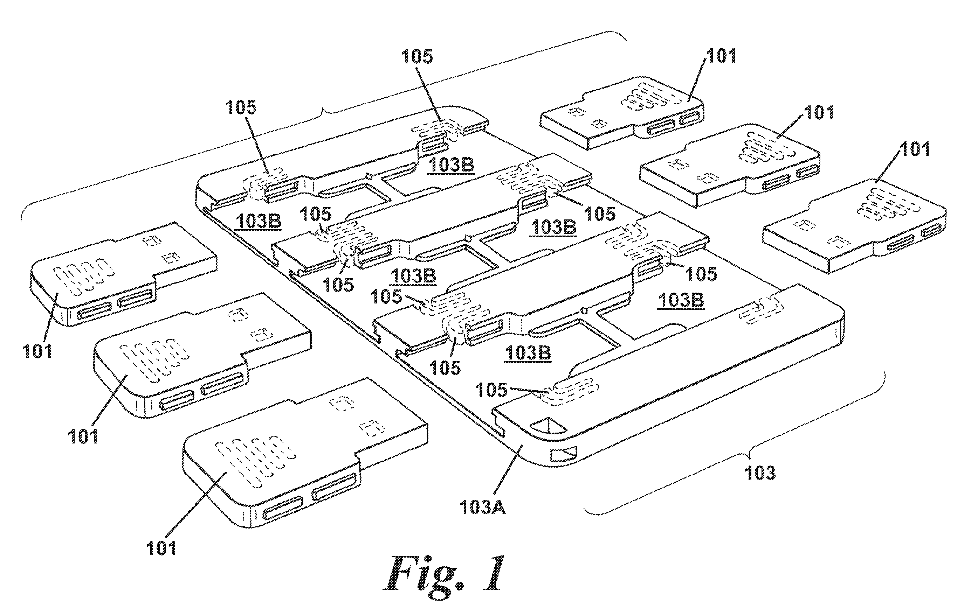

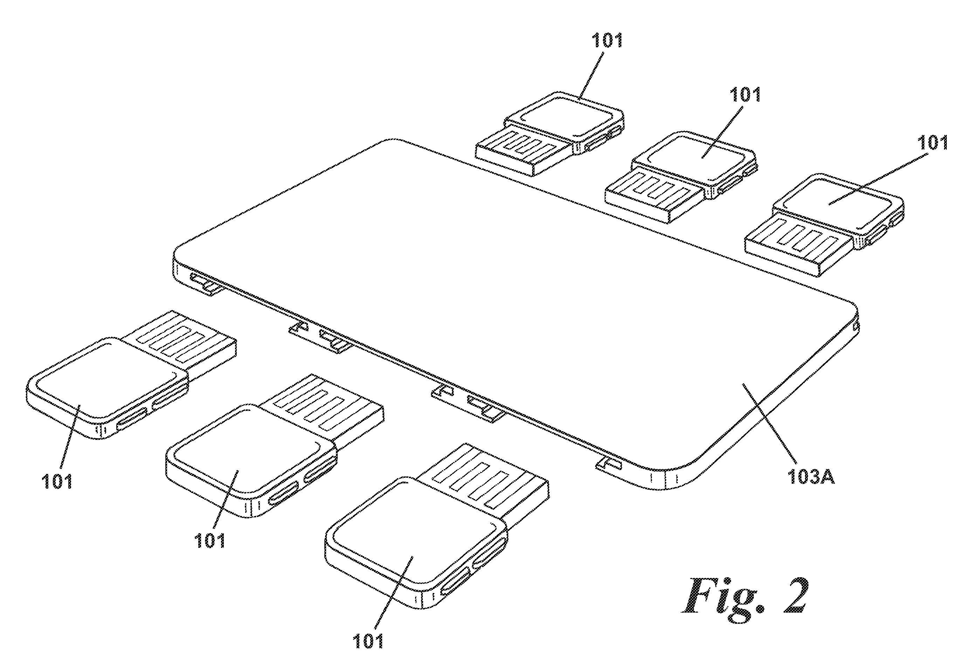

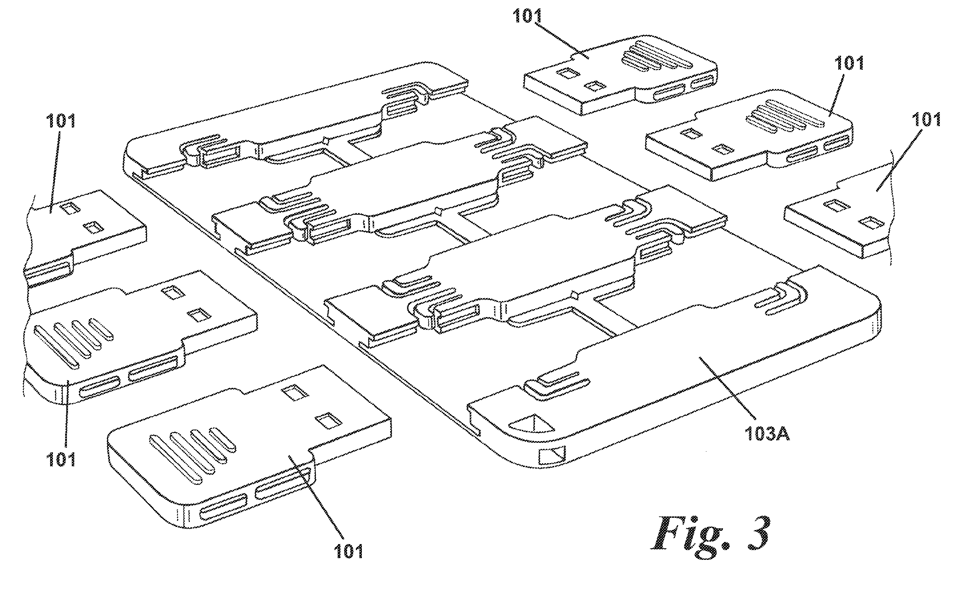

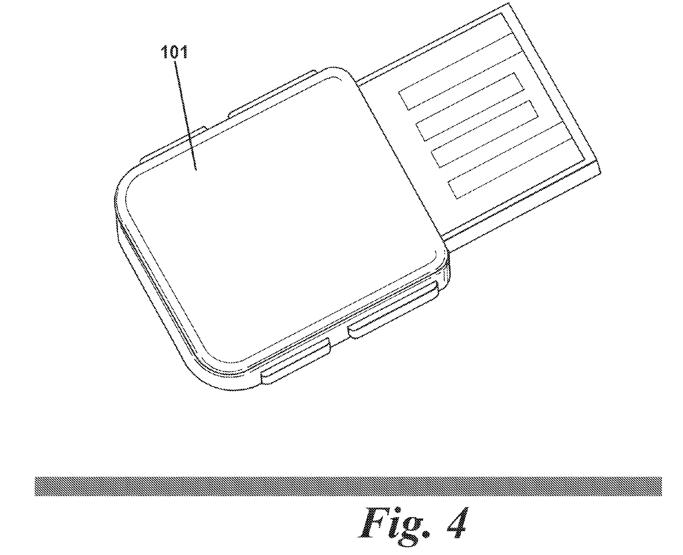

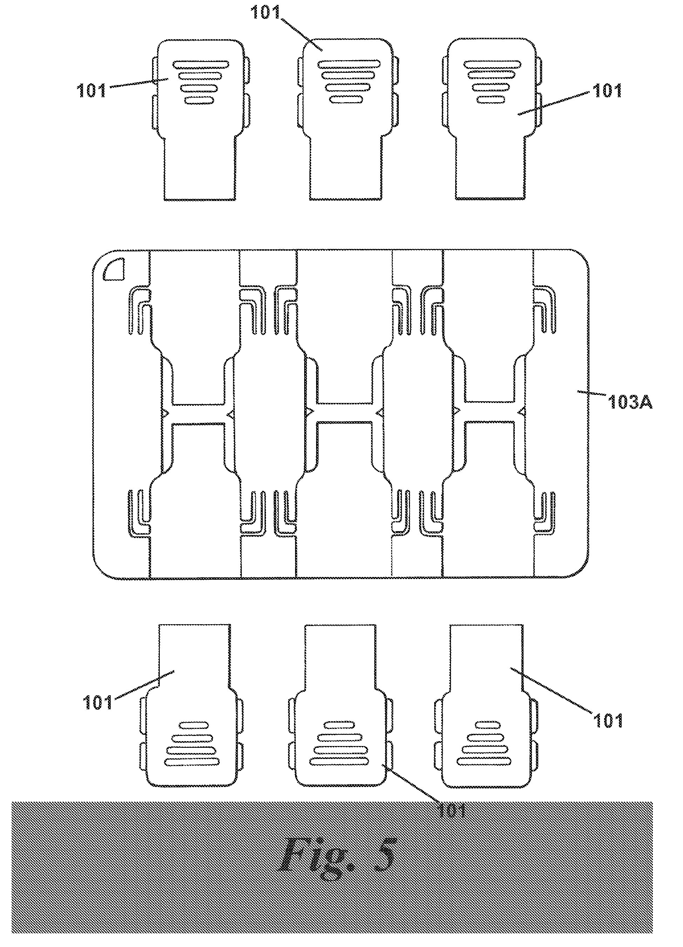

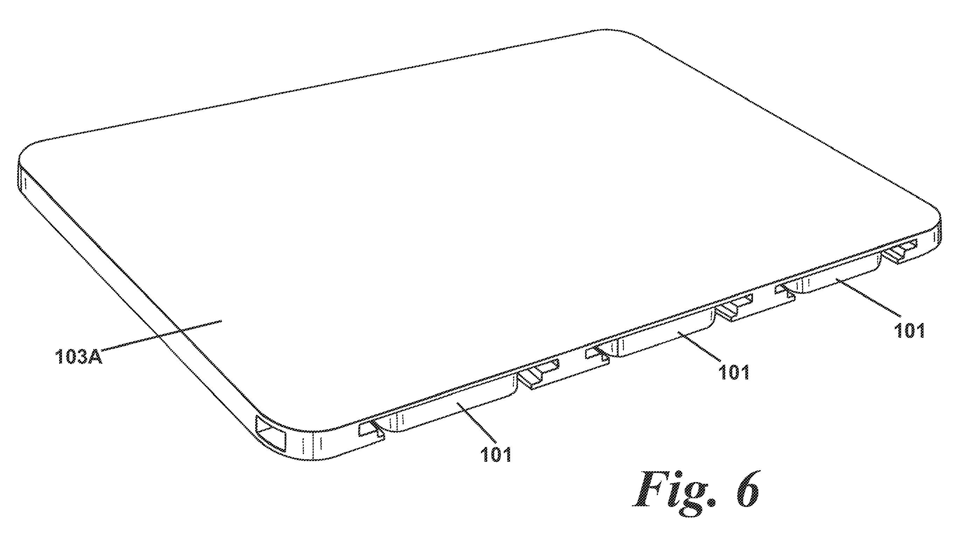

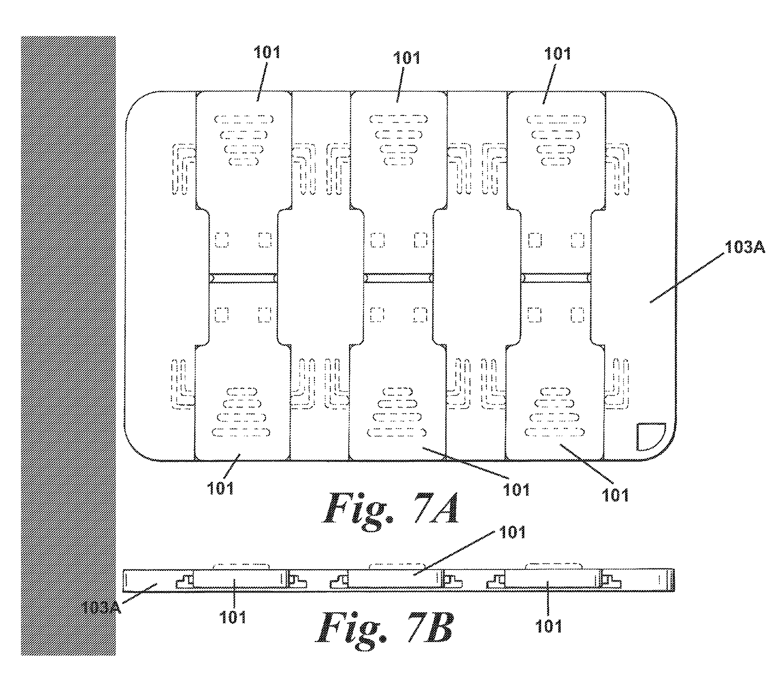

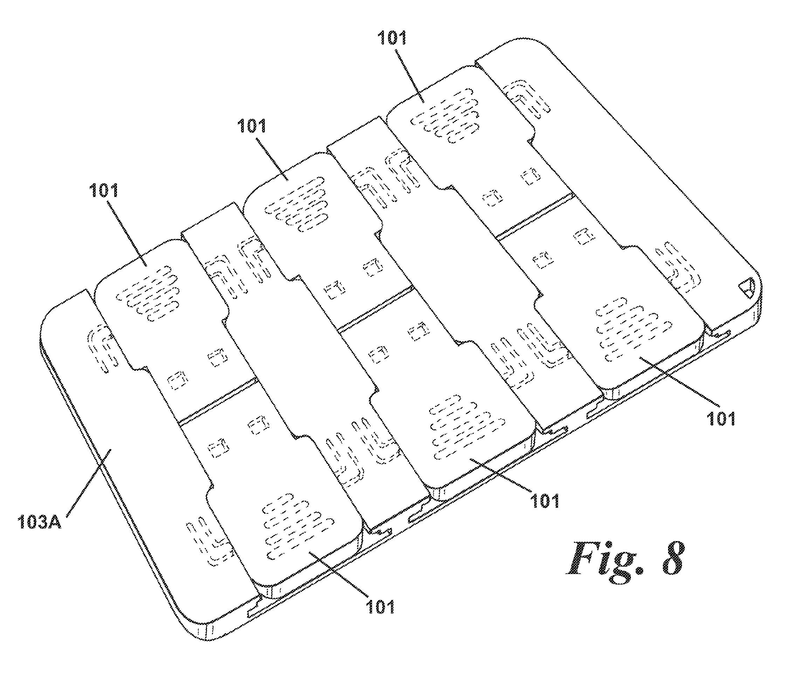

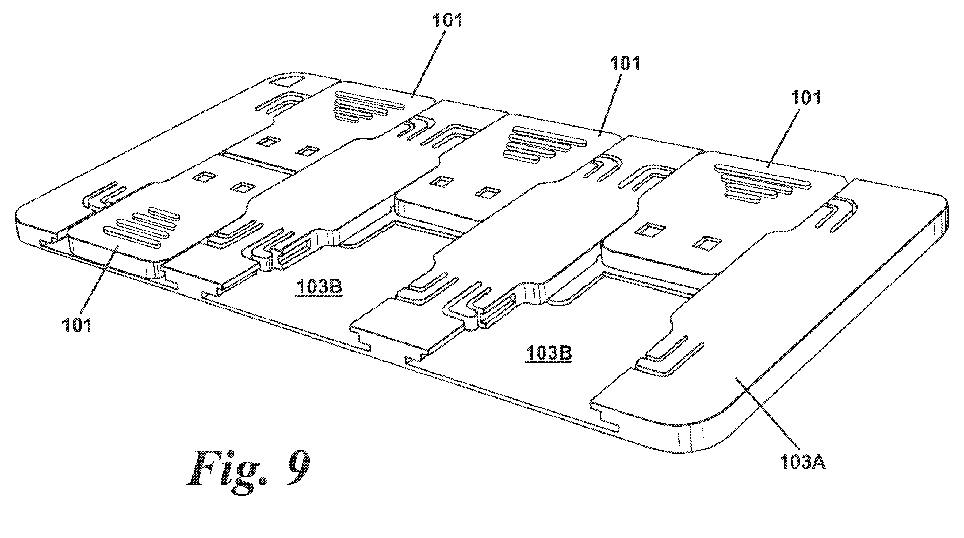

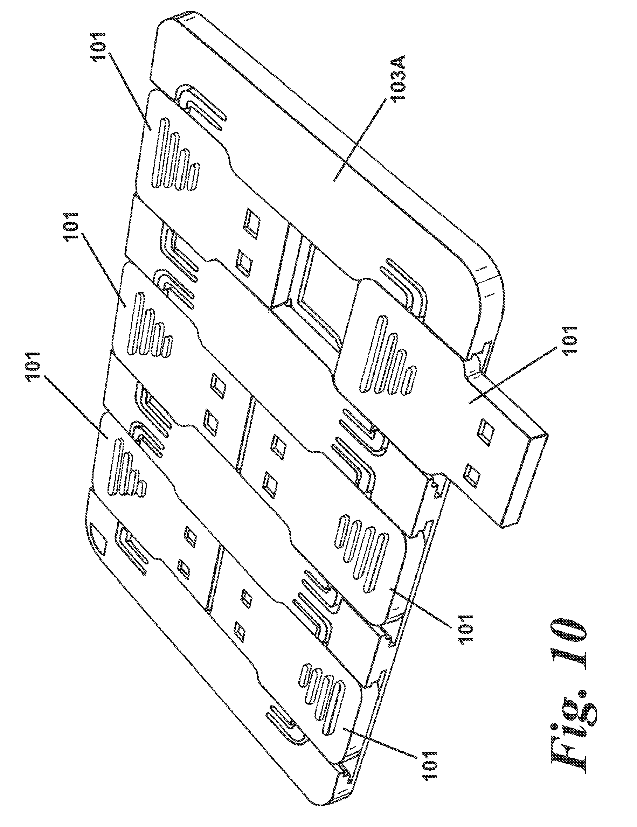

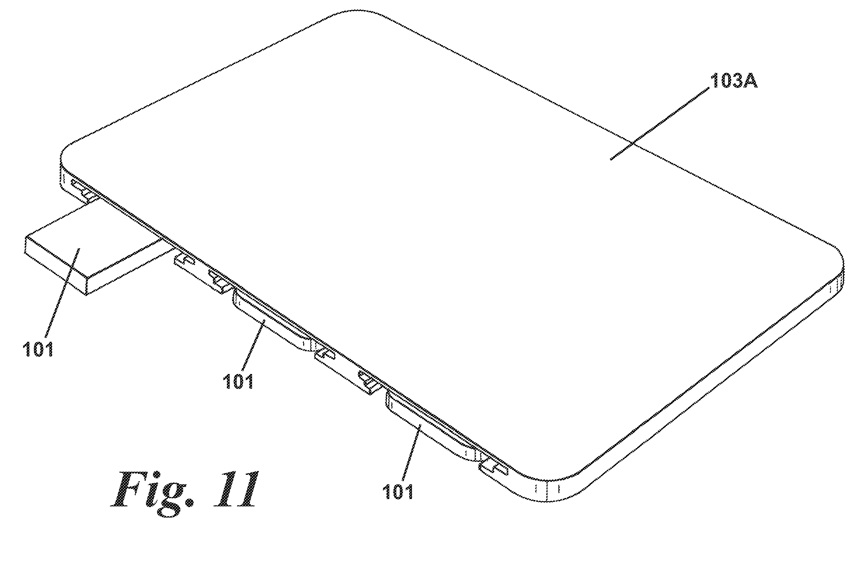

Referring now to Figs. 1-11, one embodiment of the present invention is shown. More particularly, a plurality of memory devices 101 are held by holder 103 (holder 103 may be portable and hand-held). Holder 103 comprises holder body 103A, a plurality of receiving recesses 103B (each of the plurality of receiving recesses 103B being adapted to receive a respective one of the plurality of memory devices 101), and a plurality of holding elements 105 (at least one of the plurality of holding elements being associated with each of the plurality of receiving recesses 103B to removably hold each of the plurality of memory devices 101 in a respective recess 103B).

In one example, each of the plurality of memory devices 101 may be a flash drive.

In another example, each of the plurality of memory devices 101 may be a USB flash drive.

In another example, each memory device 101 is of the same type.

In another example, at least two of the memory devices 101 are of a different type.

In another example, the holder body 103A may be generally in the form of a credit card.

In another example, there may be six memory devices 101.

In another example there may be six recesses 103B.

In another example, any desired number of recesses 103B may correspond to any desired number of memory devices 101.

In another example, each of the plurality of recess 103B may substantially correspond in shape to each of the plurality of memory devices 101.

In another example, each of the plurality of holding elements 105 may comprises at least one flexible member adapted to removably hold each of the plurality of memory devices 101 in a respective recess 103B.

In another example, each of the plurality of recesses 103B may have associated therewith a plurality of flexible members.

In another example, the holder body may have a top and a bottom, wherein each of the plurality of recesses is disposed in the top of the holder body.

In another example, the holder body may have a top and a bottom, wherein each of the plurality of recesses is disposed in the bottom of the holder body.

In another example, the holder body may have a top and a bottom, wherein each of the plurality of recesses is disposed between the top of the holder body and the bottom of the holder body.

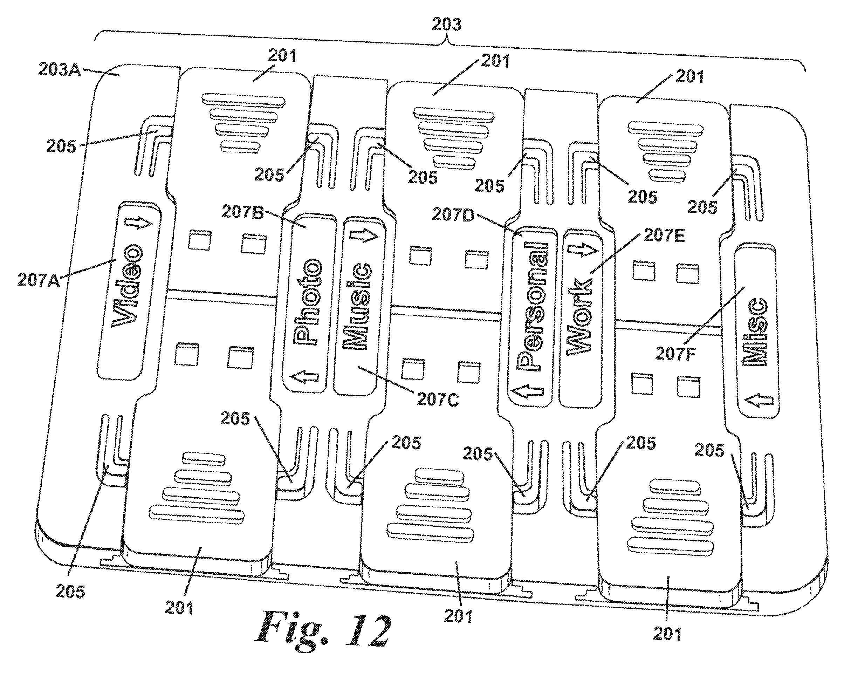

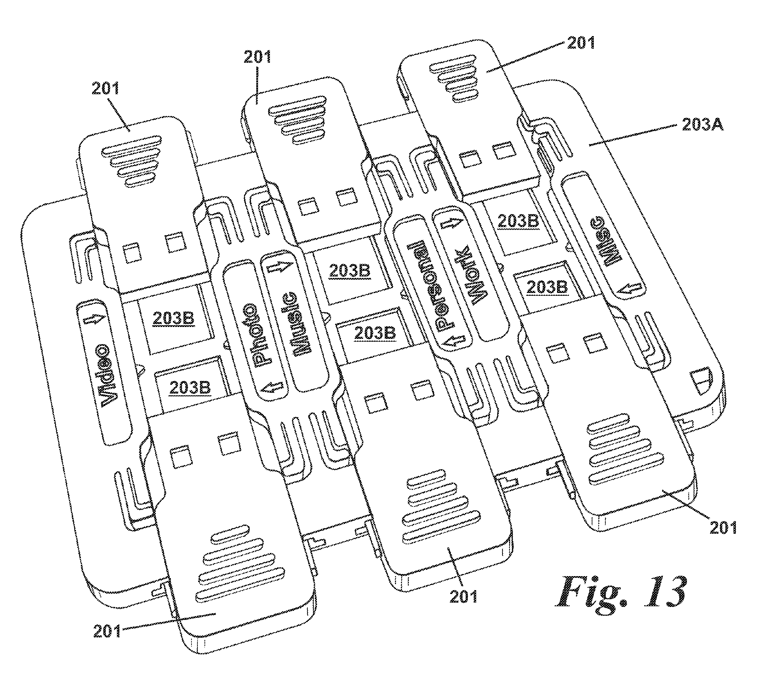

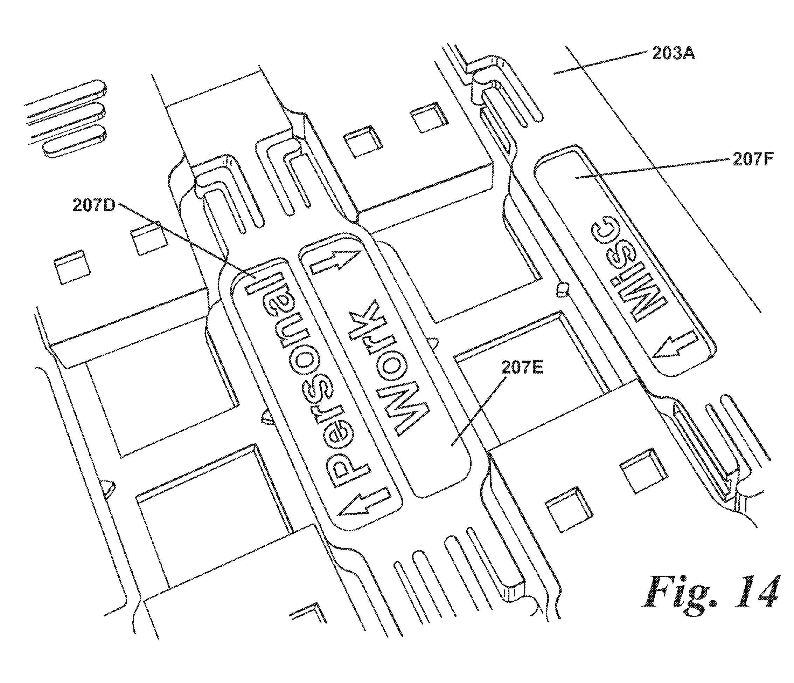

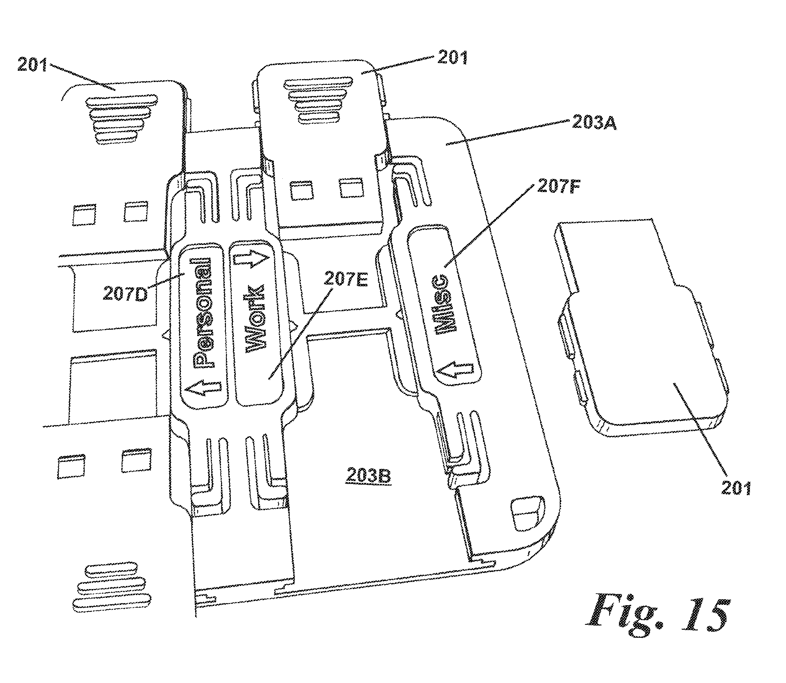

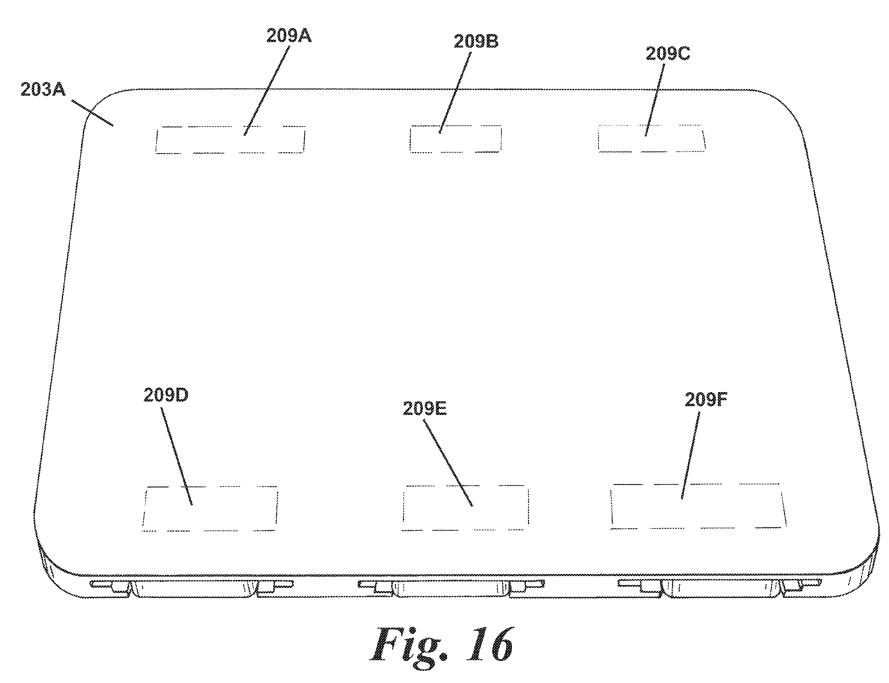

Referring now to Figs. 12-16, another embodiment of the present invention is shown. More particularly, a plurality of memory devices 201 are held by holder 203 (holder 203 may be portable and hand-held). Holder 203 comprises holder body 203A, a plurality of receiving recesses 203B (each of the plurality of receiving recesses 203B being adapted to receive a respective one of the plurality of memory devices 201), and a plurality of holding elements 205 (at least one of the plurality of holding elements being associated with each of the plurality of receiving recesses 203B to removably hold each of the plurality of memory devices 201 in a respective recess 203B).

Of note, in this example, indicia 207A-207F are provided on the top of holder body 203A adjacent each of the plurality of recesses 203B (wherein each of the indicia identifies a respective one of the plurality of memory devices 201). Moreover, indicia 209A-209F are provided on the bottom of holder body 203A (wherein each of the indicia identifies a respective one of the plurality of memory devices 201). In one specific example, the indicia are selected from the group including (but not limited to) of: video, photo, music, personal, work, miscellaneous.

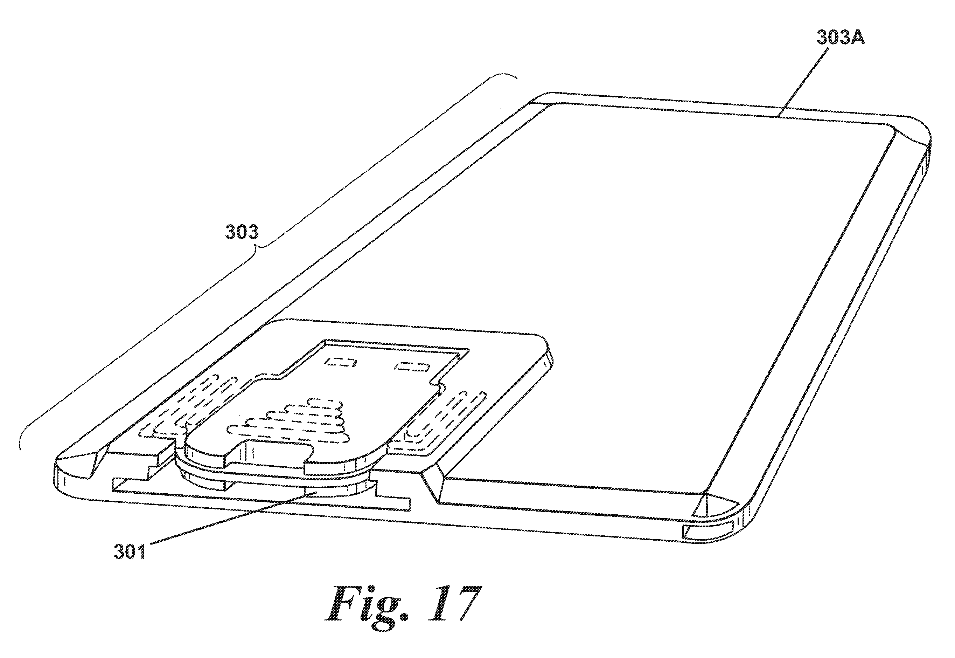

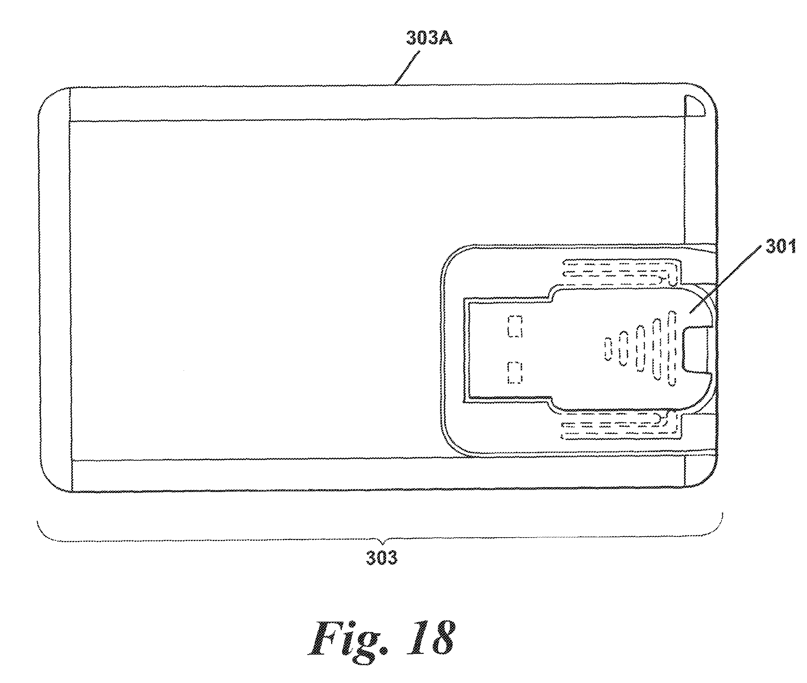

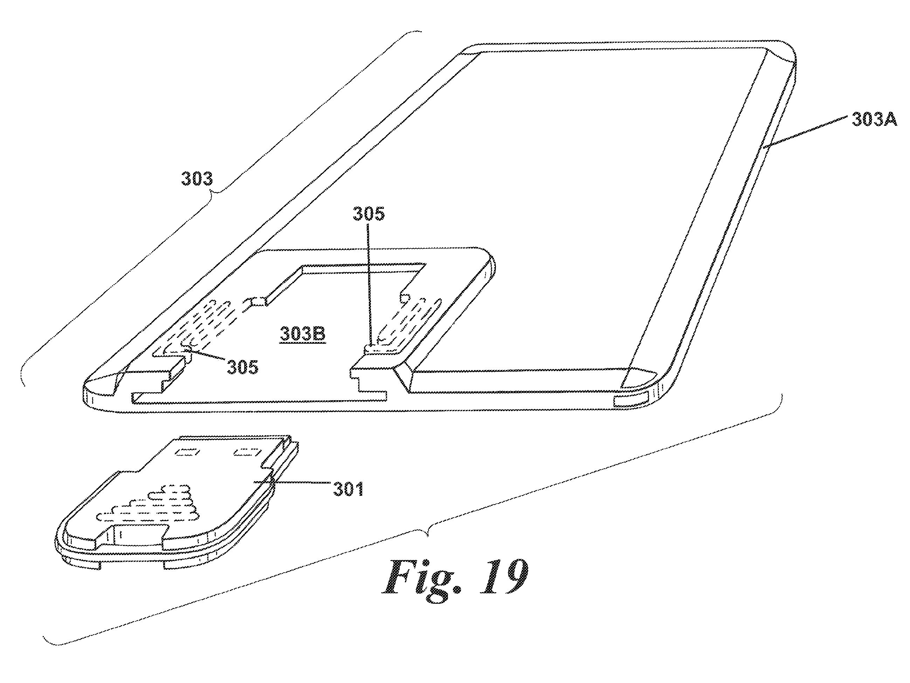

Referring now to Figs. 17-19, another embodiment of the present invention is shown. More particularly, a single memory device 301 is held by holder 303 (holder 303 may be portable and hand-held). Holder 303 comprises holder body 303A, a receiving recess 303B (the receiving recess 303B being adapted to receive the memory device 301), and a plurality of holding elements 305 (at least one of the plurality of holding elements being associated with the receiving recess 303B to removably hold the memory device 301 in recess 303B).

As described herein, the memory devices may be held in one example by the holder for storage and/or deployment utilizing molded flexible "fingers" as shown in the drawings (of course, other mechanisms for holding the memory devices for storage and/or deployment may be utilized).

While a number of embodiments of the present invention have been described, it is understood that these embodiments are illustrative only, and not restrictive, and that many modifications may become apparent to those of ordinary skill in the art. For example, the holder may hold any desired number of memory devices. In one specific example, the holder may hold at least two memory devices. In another specific example, the holder may hold at least three memory devices. In another specific example, the holder may hold at least four memory devices. In another specific example, the holder may hold at least five memory devices. In another specific example, the holder may hold at least six memory devices. Further, memory device(s) instead of (or in addition to) flash drive(s) may held by the holder. Further still, the holder may be constructed to protect the electrical connection(s) of the memory device(s) when held in the stored position. Further still, the holder may be constructed of any desired materials (e.g., plastic). Further still, the holder may be in any desired shape (e.g., a credit card shape). Further still, any desired advertising may be applied to the holder (e.g., text and/or images printed on the holder, text and/or images molded into the holder). Further still, the holder may be in the shape of any desired advertising (e.g., the shape of the holder itself may form a trademark and/or advertising slogan). Further still, the holder may hold the plurality of memory devices without electrically interfacing with the plurality of memory devices - that is, the holder may simply be a holder and not a conduit for carrying data between the memory devices and a computer. Further still, the present invention is intended to include one or more methods for constructing the type of holder described herein. Further still, any desired type and number of indicia for identifying the memory devices may be provided. Further still, any steps described herein may be carried out in any desired order (and any additional steps may be added and/or deleted).

## Claims

1. An apparatus for storing a plurality of memory devices, comprising:
a portable holder body;
a plurality of receiving recesses, each of the plurality of receiving recesses being adapted to receive a memory device; and
a plurality of holding elements, at least one of the plurality of holding elements being associated with each of the plurality of receiving recesses to removably hold a memory device in a respective recess;
wherein the holder body is adapted to hold a plurality of memory devices but not to electrically interface with any held memory devices.

2. The apparatus of claim 1, wherein each of the recesses is adapted to hold a USB flash drive.

3. The apparatus of claim 1, wherein each of the recesses is adapted to hold a flash drive.

4. The apparatus of any of claims 1 to 3, wherein the holder body is generally in the form of a credit card.

5. The apparatus of any of claims 1 to 4, wherein each of the plurality of holding elements comprises at least one flexible member adapted to removably hold a memory device in a respective recess.

6. The apparatus of claim 5, wherein each of the plurality of recesses has associated therewith a plurality of flexible members.

7. The apparatus of any of claims 1 to 6, wherein the holder body has a top and a bottom, and wherein each of the plurality of recesses is disposed in the top of the holder body.

8. The apparatus of any of claims 1 to 6, wherein the holder body has a top and a bottom, and wherein each of the plurality of recesses is disposed in the bottom of the holder body.

9. The apparatus of any of claims 1 to 6, wherein the holder body has a top and a bottom, and wherein each of the plurality of recesses is disposed between the top of the holder body and the bottom of the holder body.

10. The apparatus of any of claims 1 to 9, wherein there are six recesses.

11. A computer memory system comprising:
a plurality of memory devices; and
a portable holder for a plurality of memory devices, according to any of claims 1 to 10.

12. The system of claim 11, wherein each memory device is of the same type.

13. The system of claim 11, wherein there are six memory devices.

14. The system of claim 11, wherein each of the plurality of recesses substantially corresponds in shape to each of the plurality of memory devices.
